(19) Europäisches Patentamt / European Patent Office / Office européen des brevets

(11) **EP 3 089 365 A1**

(12) **EUROPEAN PATENT APPLICATION**

(43) Date of publication:
**02.11.2016 Bulletin 2016/44**

(51) Int Cl.:
***H03H 7/20*** *(2006.01)*     ***H03H 7/25*** *(2006.01)*
***H03H 7/48*** *(2006.01)*     ***H03H 7/52*** *(2006.01)*

(21) Application number: **15305639.5**

(22) Date of filing: **27.04.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **ALCATEL LUCENT**
**92100 Boulogne-Billancourt (FR)**

(72) Inventors:
• **Bulja, Senad**
  **Dublin, 15 (IE)**
• **Gimersky, Martin**
  **Dublin, 15 (IE)**
• **Rulikowski, Pawel**
  **Dublin, 15 (IE)**

(74) Representative: **Mills, Julia et al**
**Script IP Limited**
**18 Bridge Street**
**Frome Somerset BA11 1BB (GB)**

Remarks:
Amended claims in accordance with Rule 137(2) EPC.

(54) **DIRECTIONAL DEVICE FOR PHASE SHIFTING AND ATTENUATING SIGNALS**

(57)    A device operable to control a phase shift and attenuation of a signal is disclosed. The device comprises: a directional device comprising an input port for receiving the signal, an output port for outputting an output signal and at least one further port, the directional device being operable to direct the signal received at the input port towards the at least one further port; a variable capacitor and variable resistor in data communication with the at least one further port; and at least one control signal input operable to receive at least one control signal and to route the at least one control signal to control a capacitance of the variable capacitor and to control a resistance of the variable resistor. The at least one further port is operable to reflect the signal, an attenuation and phase shift of the reflected signal depending on the capacitance of the variable capacitor and the resistance of the variable resistor, the directional device being operable to direct the reflected signal towards the output port.

Figure 2

**EP 3 089 365 A1**

**Description**

FIELD OF THE INVENTION

The field of the invention relates to the controlled phase shift and attenuation of signals.

BACKGROUND

Variable phase shifters and attenuators are widely used in telecommunications. Their applications include radar systems, amplifier linearization, point-to-point radio and RF signal cancellation among others. The choice of phase shifter for any given application is influenced by many factors, such as the amount of obtainable phase shift, the insertion loss and the power-handling capability. Similarly, the choice of an attenuator for a particular application is analogously influenced.

For lower power-handling requirements, variations of phase shift and insertion loss are adequately provided by semiconductor technology. In particular, varactor diodes are widely used as the reactance-tuneable elements needed for the variation of insertion phase, while PIN diodes are widely used as resistance tuneable elements needed for the variation of insertion loss.

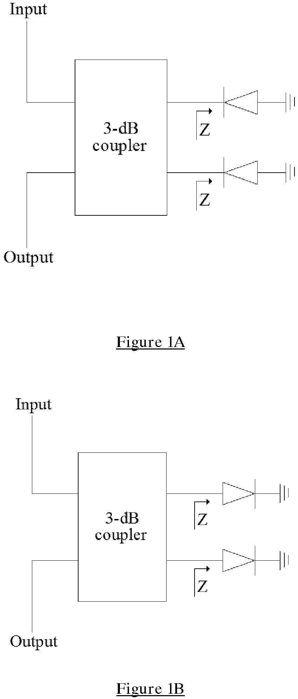

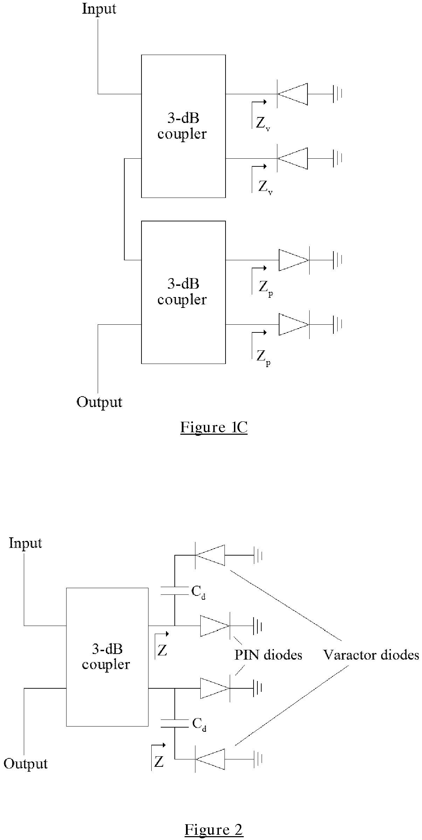

Due to cost effectiveness, reflective-type phase shifters and attenuators are widely used in telecommunications. The reflective-type structure such as is shown in Figure 1 is simple and consists of a 3-dB coupler and variable-reactance elements for the case of a phase shifter and a 3-dB coupler and variable-resistance elements for the case of an attenuator.

In many applications both phase shift and attenuation are required; it would be desirable to be able to provide a low cost, low area device able to control both of these properties.

SUMMARY

A first aspect of the present invention provides a device operable to control a phase shift and attenuation of a signal, said device comprising: a directional device comprising an input port for receiving said signal, an output port for outputting an output signal and at least one further port, said directional device being operable to direct said signal received at said input port towards said at least one further port; a variable capacitor and variable resistor in data communication with said at least one further port; at least one control signal input operable to receive at least one control signal and to route said at least one control signal to control a capacitance of said variable capacitor and to control a resistance of said variable resistor; wherein said at least one further port is operable to reflect said signal, an attenuation and phase shift of said reflected signal depending on said capacitance of said variable capacitor and said resistance of said variable resistor, said directional device being operable to direct said reflected signal towards said output port.

The inventors of the present invention recognised that although directional devices such as 3-dB couplers with appropriate variable devices are a cost and area efficient way of providing either phase shift or attenuation of a signal, if both phase shift and attenuation are required cascading the two devices to provide the two functions provides a device where losses due to the coupler and parasitic impedances are increased.

They also recognised that the degree of phase shift and attenuation provided by variable capacitors and impedances respectively can be controlled independently of each other such that for an arbitrary phase shift a variable amount of attenuation can be set and similarly for an arbitrary attenuation a variable amount of phase shift can be set. Thus, providing a directional device that can direct a signal to a port where there is both a variable capacitor and a variable resistor each controllable by a control signal allows this one device to control both phase shift and attenuation. In this way lower insertion losses, lower costs and a smaller footprint and volume can be attained.

It should be appreciated that the variable capacitor will exhibit some variation in other impedance properties as will the variable resistor, however, they are devices where the main variation is in the property being controlled.

In some embodiments, said control signal is routed to at least one of said variable capacitance and said variable resistor via a resistor, a resistance of said resistor determining a magnitude of said control signal input to control said at least one of said variable capacitor and said variable resistor.

It may be that the device is to be used to provide a particular attenuation and particular phase shift and in such a case, there may be a single control signal for setting the capacitance of the variable capacitor and the resistance of the variable resistor respectively with a resistor being used to control the magnitude of at least one of the signals such that the desired capacitance and resistance can be achieved from this single signal. In this regard, the resistor controlling the magnitude of the control signal may be a variable resistor or it may be a resistor that has been selected in the knowledge of the desired phase shift and attenuation. One way of providing such control signals may be to use one of the biasing voltages and one or more resistors or potential dividers to control the voltage input as a control signal to the variable capacitor and resistor.

In other embodiments, said at least one control signal input is operable to receive two control signals, an

2

attenuation control signal and a phase shift control signal, and to route said attenuation control signal to control a resistance of said variable resistor and to route said phase shift control signal to control a capacitance of said variable capacitor.

In many cases, two control signals will be received at the device, an attenuation control signal and a phase shift control signal and these can be used to independently control the attenuation and the phase shift of the signal by controlling the resistance of the variable resistor and the capacitance of the variable capacitor.

In some embodiments, said variable capacitor and said variable resistor are arranged in series with each other, while in other embodiments, said variable capacitor and said variable resistor are arranged in parallel with each other.

Arranging the variable capacitor and variable resistor in parallel with each other means that parasitic impedances due to these devices will also be in parallel and as such, any parasitic resistance will be reduced. This clearly is advantageous. Furthermore, it provides an advantage over a cascaded phase shifter and attenuator where the parasitic resistances are summed.

In some embodiments, the device further comprises a high pass filter arranged between said variable capacitor and said variable resistor.

It may be desirable to provide DC isolation between the variable capacitor and the variable resistor and a high pass filter may be a convenient way of doing this. In this regard, where the devices are controlled by independent control signals then isolation of these control signals from each other may be desirable and a high pass filter will achieve this. Furthermore, by careful selection of the high pass filter, the transient reaction of the circuit and the speed of control of changes in phase shift and attenuation can be improved.

In some embodiments, said high pass filter comprises a decoupling capacitor.

One low cost way of providing a high pass filter is to provide a capacitor which acts to decouple either side of the capacitor from any DC levels.

In some embodiments, said directional device comprises a circulator.

A circulator is a passive device which transmits a signal from one port to a subsequent port and impedes a signal from flowing in the opposite direction. Such a device is a convenient directional device and can be used in conjunction with variable capacitors and resistors to provide a variable phase shifter and attenuator according to embodiments.

In some embodiments, said directional device comprises two further ports, said directional device being operable to direct an input signal from said input to said two further ports, and to direct reflected signals from each of said two further ports to both said input port and said output port; said device further comprising a further variable capacitor and a further variable impedance, said variable capacitor and said variable resistor being in data communication with one of said two further ports and said further variable capacitor and said further variable resistor being in data communication with another of said two further ports, a phase shift and attenuation of said reflected signals from each of said two further ports depending on a value of a capacitance and resistor of said variable capacitor and said variable resistor in data communication with said respective further port.

An alternative directional device may be one with an input and output port and with two further ports, the two further ports directing reflected signals to both the input port and the output port. These two further ports have further variable capacitors and further variable impedances and these are used to control the phase shift and attenuation of the reflected signals.

In some embodiments, said directional device comprises a 3-dB coupler, and said variable capacitor and said variable resistor are matched to said further variable capacitor and said further variable resistor such that said reflected signals received at said output port from each of said two further ports are substantially the same, and reflected signals received at said input port from each of said two further ports are substantially 180° out of phase with each other.

The provision of an additional further port and additional variable capacitors and resistors has an overhead, however, it is a convenient way of providing a directional device that does not allow reflected signals to return to the input port where they would interfere with the input signal but allows reflected signals to travel with low impedance to the output port. This is achieved using the two further ports to reflect the signals and make use of the phase changes that occur here. Provided that the variable resistors and capacitors on the two further ports are matched the reflected signals will cancel each other out at the input port and add together at the output port. Thus, although additional devices are needed on the further ports, the directional device itself is a low cost low area device and as such it provides a low cost and efficient phase shifter and attenuator.

Although the variable capacitor can take any form provided that one can control the level of the capacitance, in some embodiments it comprises at least one of a varactor diode and a transistor. These are low cost components that provide controllable capacitances in a low cost and low area manner.

Furthermore, although the variable resistor can take a number of different forms, in some embodiments it comprises at least one other PIN diode and a transistor. Again, these are low cost, low area solutions to providing a variable resistance.

When a varactor diode is used as a tuneable reactance element in the design of a phase shifter, the parameter of importance is the ratio of the maximum and minimum capacitances (referred to as rc = $C_{max}/C_{min}$). Normally, the greater this ratio is, the greater is the amount of obtainable phase shift; the ratio is usually between 3 and 10. Similarly, when a PIN diode is used as a resistance-tuneable element in the design of attenuators, the parameter of importance is the ratio between the "on" and "off" resistance states (referred to as rr = $R_{max}/R_{min}$); typically the ratio varies between 30 and 50 dB.

A second aspect of the present invention provides a method of varying a phase shift and attenuation of a signal, said method comprising: receiving said signal at an input port of a directional device; directing said signal towards at least one further port of said directing device; receiving at least one control signal; routing said at least one control signal to control a capacitance of a variable capacitor and to control a resistance of a variable resistor; reflecting said signal at said at least one further port, an attenuation and phase shift of said reflected signal depending on said capacitance of said variable capacitor and said resistance of said variable resistor; and directing said reflected signal towards an output port of said directional device.

In some embodiments, said step of receiving at least one control signal comprises receiving two control signals, an attenuation control signal and a phase shift control signal; and said step of routing said control signals comprises routing said attenuation control signal to control a resistance of said variable resistor and routing said phase shift control signal to control a capacitance of said variable capacitor.

In some embodiments, said directional device is a 3-dB coupler and comprises two further ports, and said directing step comprises directing said signal from said input to said two further ports; and said step of directing said reflected signals comprises directing said reflected signals from each of said two further ports to both said input port and said output port, a phase shift and attenuation of said reflected signals from each of said two further ports depending on a value of a capacitance of a variable capacitor and a resistance of a variable resistor in data communication with said respective further port, wherein said variable capacitor and said variable resistor at each of said further ports are matched with each other such that said reflected signals received at said output port from each of said two further ports are substantially the same, and reflected signals received at said input port from each of said two further ports are substantially 180° out of phase with each other.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

BRIEF DESCRIPTION OF THE DRAWINGS

Embodiments of the present invention will now be described further, with reference to the accompanying drawings, in which:

Figure 1A shows a variable phase shifter according to the prior art;
Figure 1B shows a variable attenuator according to the prior art;
Figure 1C shows a variable attenuator and phase shifter consisting of the devices of
Figure 1A and Figure 1B cascaded together according to the prior art;
Figure 2 shows a circuit comprising a combined phases shifter and attenuator according to an embodiment;
Figure 3 shows a further embodiment of a combined phase shifter and attenuator;
Figure 4 shows an equivalent circuit for a PIN diode;
Figure 5A shows parametric variation of insertion phase of a device according to Figure 3 with an insertion loss of 1.13dB;
Figure 5B shows parametric variations of the same device with an insertion loss of 3dB;
Figure 5C shows parametric variations of the same device with an insertion loss of 6dB;
Figure 5D shows parametric variation of insertion phase of the same device with insertion loss of 9dB;
Figure 5E shows parametric variation of insertion phase of the same device with insertion loss of 12dB;
Figure 6A shows parametric variations of insertion phase of the structure according to the prior art as shown in Figure 1C with insertion loss of 1.8dB;
Figure 6B shows parametric variations of the same device with insertion loss of 3dB;
Figure 6C shows parametric variation of insertion phase of the same device with insertion loss of 6dB;
Figure 6D shows parametric variations of insertion phase of the same device with insertion loss of 9dB;
Figure 6E shows parametric variations of insertion phase of the same structure with insertion loss of 12dB;
Figure 7 shows a polygon delimiting the envelope of achievable phase shift and attenuation levels at 2.5GHz for the structure of Figure 3;
Figure 8 shows a corresponding polygon delimiting the envelope of achievable phase shift and attenuation levels at 2.5GHz for the structure of the prior art shown in Figure 1C;

Figure 9 shows an embodiment of a combined phase shifter and attenuator with series connection of PIN diodes and varactor diodes according to an embodiment;

Figure 10 shows an embodiment of a combined variable phase shifter and attenuator with parallel connections of PIN and varactor diodes with a high pass filter;

Figure 11 an embodiment of a combined variable phase shifter and attenuator with series connection of PIN and varactor diodes and a high pass filter; and

Figure 12 shows a variable phase shifter and attenuator comprising a circulator according to an embodiment.

## DESCRIPTION OF THE EMBODIMENTS

Before discussing the embodiments in any more detail, first an overview will be provided.

Embodiments seek to provide a combined variable phase shifter and attenuator. In some embodiments a single 3-dB coupler is used in conjunction with a variable resistor and a variable capacitor.

Embodiments can employ a variety of electronic components to achieve the variations in capacitance and resistance in conjunction with any directional device. One example of a variable capacitor that can be used is a varactor, while an example of a variable resistor is a PIN diode.

A variable phase shifter according to the prior art is shown in Figure 1A. The variable capacitor, Z, is a varactor diode in this example, while in Fig. 1B which shows a variable attenuator according to the prior art the variable element, Z, is designated to be a PIN diode. The operational principles of the reflective-type phase shifter and attenuator are similar and can be explained using the same derivation. If we assume that the 3-dB coupler is lossless and that the "coupled" and "through" arms of the 3-dB coupler have reflection coefficients given by $\Gamma_1$ and $\Gamma_2$, respectively, the overall reflection and transmission coefficients of the reflective structure become

$$S_{11} = 0.5(\Gamma_1 - \Gamma_2) \text{ and } S_{21} = -j0.5(\Gamma_1 + \Gamma_2) \ (1)$$

If the reflective loads are the same, i.e., $\Gamma_1 = \Gamma^2 = \Gamma$, it follows that $S_{11} = 0$ and $S_{21} = -j\Gamma$, inferring that the structure formed in this way is always properly impedance-matched (within the bandwidth of the 3-dB coupler) and that the reflection coefficient of the reflective loads, $\Gamma$, becomes the transmission coefficient of the reflective structure. As such, any changes in the phase or magnitude of the reflection coefficient $\Gamma$ directly translate to changes of the transmission coefficient of the reflective structure, i.e., $S_{21}$. The general expression for the transmission coefficient can be written as

$$S_{21} = -j\Gamma = \frac{Z - Z_0}{Z + Z_0} = \left| \frac{Z - Z_0}{Z + Z_0} \right| \cdot e^{j\left( -\frac{\pi}{2} + arctan\left( \frac{Im(Z)}{real(Z) - Z_0} \right) - arctan\left( \frac{Im(Z)}{real(Z) + Z_0} \right) \right)} \ (2)$$

where $Z_0$ is the characteristic impedance of the system. For the case of a reflective-type phase shifter, the varactor diode of Fig 1A is, ideally, represented as a variable capacitance, C, with a negligible parasitic resistance. In this case, the transmission coefficient of (2) can be written as

$$S_{21} = -j\Gamma = -j \frac{\omega C Z_0 + j}{j - \omega C Z_0} = e^{j\left( -\frac{\pi}{2} + 2arctan\left( \frac{1}{\omega C Z_0} \right) \right)} \ (3)$$

where $\omega$ is the angular frequency. The phase of the transmission coefficient of (3) can be written as

$$arg(S_{21}) = -\frac{\pi}{2} + 2\,arctan\left( \frac{1}{\omega C Z_0} \right) (4)$$

Since the varactor diode capacitance, C, is variable, the amount of introduced phase shift by (4) is also variable.

For the case of a reflective-type attenuator, the PIN diode of Fig. 1B is ideally represented by a variable resistance, R, and the transmission coefficient now becomes

$$S_{21} = -j\Gamma = \frac{Z - Z_0}{Z + Z_0} = \left| \frac{R - Z_0}{R + Z_0} \right| \cdot e^{-j\frac{\pi}{2}} \quad (5)$$

where the magnitude of the transmission coefficient of (3) can be written as

$$|S_{21}| = \left| \frac{R - Z_0}{R + Z_0} \right| \quad (6)$$

As in the case of the phase shifter, since the PIN diode resistance, R, is variable, the amount of introduced attenuation (6) is variable, too.

In certain applications, such as beamforming networks for antenna arrays, one requires not only to control phase but also to control amplitude; for example, phase distribution across an antenna-array aperture steers the antenna beam (main lobe), while amplitude distribution can be effectively used for sidelobe control. This means that if devices such as those shown in Figures 1A and 1B were used, two separate devices are needed for each radiating element of the array or each subarray - one device for phase shifting and one device for attenuation control. Figure 1C shows how the devices of Figures 1A and 1B may be cascaded together to provide both phase shift and attenuation control in effect by combining two devices. This cascading of devices provides a significant overhead in component costs, volume and mass.

An RF device that simultaneously combines the functions of a variable phase shifter and a variable attenuator in a single device is proposed to address these issues.

The principle of operation is similar to that already described above for the case of the isolated phase shifter and attenuator. Let us assume, as assumed above, that the varactor and PIN diodes can be represented by the equivalent variable capacitor, C, and variable resistor, R, respectively. The capacitor $C_d$ in Fig. 2 is a decoupling capacitor, chosen to decouple the direct-current (DC) power supplies of the varactor and PIN diodes, while behaving like a short circuit at RF frequencies. In the steady state, the impedance of the combined load, Z, formed with the varactor and PIN diodes can be written as

$$Z = \frac{R - j\omega C R^2}{1 + \omega^2 C^2 R^2} \quad (7)$$

while the corresponding reflection coefficient at the loads can be written as

$$\Gamma = \frac{R - Z_0 - \omega^2 C^2 R^2 Z_0 - j\omega C R^2}{R + Z_0 + \omega^2 C^2 R^2 Z_0 - j\omega C R^2} \quad (8)$$

Provided that the 3-dB coupler is ideal, the magnitude of the reflection coefficient of (8) is the same as the overall transmission coefficient of the circuit of Fig. 2, i.e.

$$|\Gamma| = |S_{21}| = \sqrt{\frac{\left( R - Z_0 - \omega^2 C^2 R^2 Z_0 \right)^2 + \omega^2 C^2 R^4}{\left( R + Z_0 + \omega^2 C^2 R^2 Z_0 \right)^2 + \omega^2 C^2 R^4}} \quad (9)$$

while the phase of the overall transmission coefficient is shifted by $\frac{\pi}{2}$ from the phase of the reflection coefficient at the loads:

$$arg(S_{21}) = arctan\left( \frac{\omega C R^2}{R + Z_0 + \omega^2 C^2 R^2 Z_0} \right) - arctan\left( \frac{\omega C R^2}{R - Z_0 - \omega^2 C^2 R^2 Z_0} \right) - \frac{\pi}{2} \quad (10)$$

It can be shown that for the case of $C = 0$, (9) reduces to (6) and for $R \rightarrow \infty$, (10) reduces to (4). In other words, by setting the capacitance of the varactor diode, C, to a minimum, the structure of Fig. 2 behaves like a variable attenuator, while setting the resistance of the PIN diode, R, to be infinite, the circuit of Fig. 2 behaves like a phase shifter. The appropriate settings of the varactor and PIN diodes are obtained using control signals which in some embodiments are supplied as DC bias signals- this will be elaborated on later.

In this way, it is shown that the structure of Fig. 2 can simultaneously behave as a phase shifter and as an attenuator. However, of even greater practical importance is the case when one device does not only independently behave as a phase shifter or an attenuator, but manages to perform both functions at the same time. In the present case, such a device would need to provide a variable phase shift for an arbitrary setting of attenuation and vice versa. Equations (9) and (10) demonstrate just that since, in the general case, insertion loss and phase shift are dependent of each other, inferring that for an arbitrary setting of phase shift, one can set a variable amount of attenuation. Of course, since the two equations are dependent of each other, such phase and amplitude settings would require solving the system of two equations formed from (9) and (10) in order to infer the particular values of the capacitance C and resistance R.

This is best illustrated by way of an example, which is provided below.

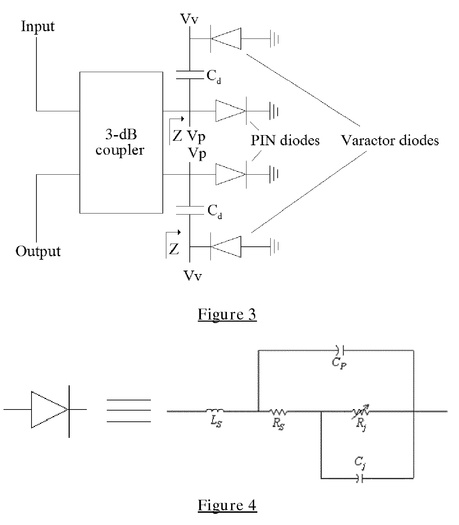

Let us consider Fig. 3, which is essentially the same as Fig. 2, but with DC bias lines provided which act as control signals for the variable capacitor and resistor.

In this figure, $Vp$ and $V_v$ stand for the DC bias control voltages applied to the PIN and varactor diodes, respectively, needed for the variation of the resistance and capacitance of the active devices. Capacitor $C_d$ is, as mentioned earlier, a decoupling capacitor needed for the separation of the bias voltages, $Vp$ and $V_v$.

As a numerical example, let us assume that the junction capacitance of the varactor diode varies from 0.3 to 3 pF with a series parasitic resistance of 2 $\Omega$. This infers a capacitance ratio of 10, which is not uncommon especially for varactor diodes with hyper-abrupt junctions. The PIN diode is assumed to have the equivalent circuit to that shown in Fig. 4.

In this figure, $L_s$ is the parasitic lead inductance, $R_s$ is the parasitic resistance, $C_p$ is the parasitic package capacitance, $C_j$ is the parasitic junction capacitance, *and* $R_j$ is variable junction capacitance. Typical values of the parasitic elements of the PIN diode are: $L_s = 2$ nH, $R_s = 1.5\,\Omega$, $C_p = 0.08$ pF, $C_j = 0.12$ pF, while $R_j$ is a current-dependent resistor and, ideally, its resistance changes from a perfect open to a perfect short. Next, the PIN diode's equivalent circuit of Fig. 4 was used to design a combined phase shifter and attenuator of Fig. 3 operating at a centre frequency of 2.5 GHz. However, in order to compensate for the large lead inductance, $L_s$, of the PIN diode, a compensating capacitor, $C_{COMP}$, was added in series with the PIN diode; the capacitor's value was obtained using the following relationship:

$$\omega L_S = \frac{1}{\omega C_{COMP}} \,.$$

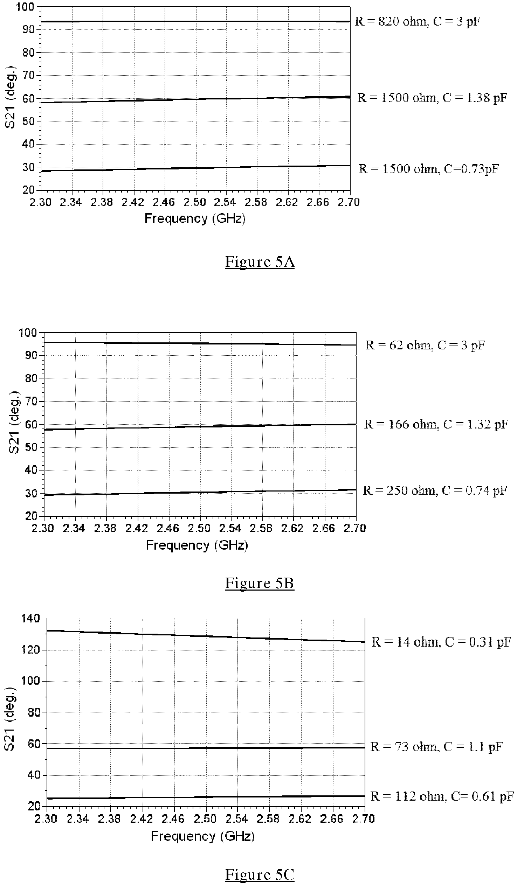

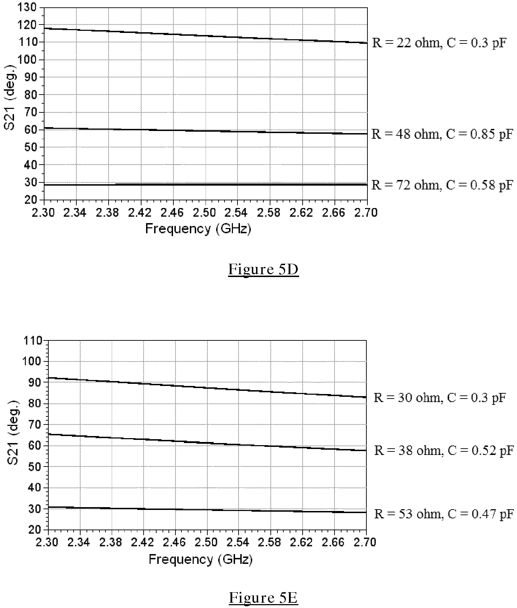

The 3-dB coupler of Fig. 3 is assumed to have an insertion loss of 0.3 dB at a centre frequency of 2.5 GHz, which is in line with the majority of surface-mount couplers available on the market. The phase-shift performance of the circuit of Fig. 3 formed from the abovementioned 3-dB coupler and varactor and PIN diodes is recorded for cases when the amount of insertion loss varies. In particular, Figs. 5A - 5E depict the parametric phase-shift response for the insertion loss values from the minimum value of 1.13 dB to 12 dB. The insertion loss of 1.13 dB is the minimum amount of insertion loss that the circuit of Fig. 3 can provide, and its value is determined by the parasitic elements of the structure: the insertion loss of the 3-dB coupler and the parasitic capacitances, inductances and resistances of the diodes.

As is evident from these figures, the variation of phase shift for a specified value of insertion loss is achieved - the typical maximum achievable phase-shift value is 104°; a minimum largest achievable phase shift is obtained for the insertion loss of 12 dB at 2.7 GHz and is equal to 83°.

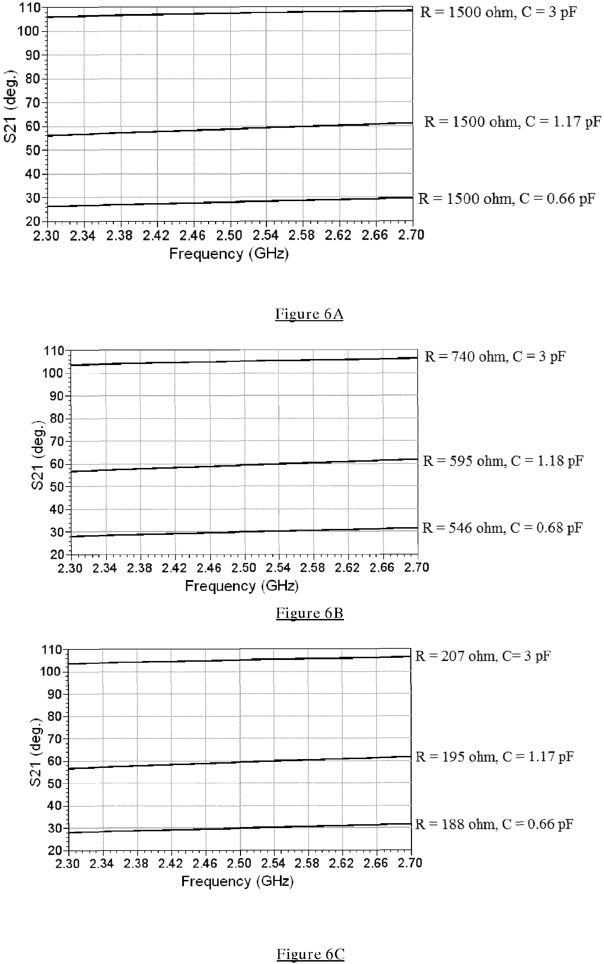

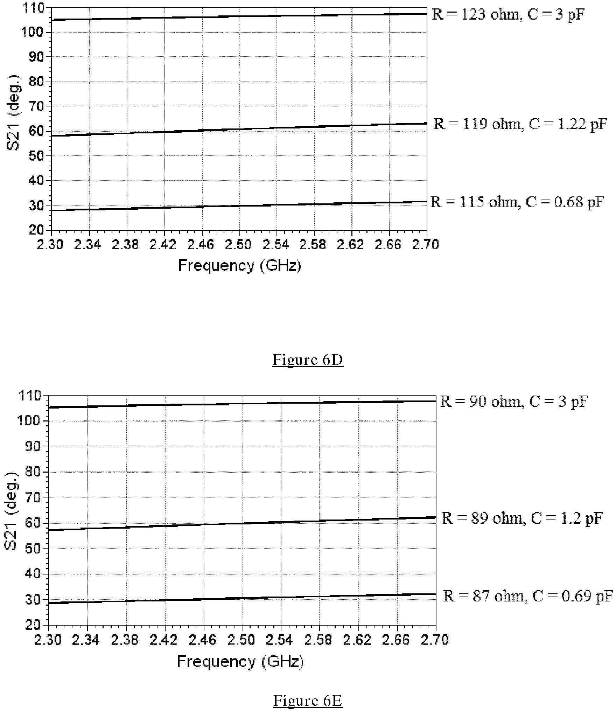

As a comparison with prior art, let us now have a look at the circuit of Fig. 1C, which uses two separate 3-dB couplers: one for the circuit of the phase shifter and one for that of the attenuator. The minimum insertion loss of this circuit is expected be higher than the combined circuit of Fig. 3, since this circuit uses an additional 3-dB coupler. The parametric phase-shift performance figures of this circuit are depicted in Figs. 6A-6E. The insertion loss of 1.8 dB is the minimum amount of insertion loss that the circuit of Fig. 1C can provide, and this value is determined by the parasitic elements of the structure: the insertion loss of the 3-dB couplers and the parasitic capacitances, inductances and resistances of the diodes.

As is evident from these figures, the variation of phase shift for a specified value of insertion loss is achieved. Compared with the case of the structure of Fig. 3, the maximum amount of phase shift provided by the structure of Fig. 1C is constant and stands at 105°. The maximum amount of phase shift of the structure of Fig. 3 varies from 85° for an insertion loss of 12dB to 125° for an insertion loss of 6 dB. The lower amount of the maximum obtainable phase shift of the structure of Fig. 3 compared to the structure of Fig. 1C should not cause a great deal of concern, since it coincides with a high-attenuation region (12 dB), where the maximum phase insertion is of lower importance than it would be in the lower-attenuation regions; for example, in antenna arrays, the higher is the attenuation of the signal fed to a particular radiating element, the lower is the importance of the element's phase setting - since the element's contribution to the overall radiation of the array is less pronounced. Of a far greater importance is the ability of the circuit of Fig. 3 to provide similar levels of phase shift as the circuit of Fig. 1C, but with a lower insertion loss.

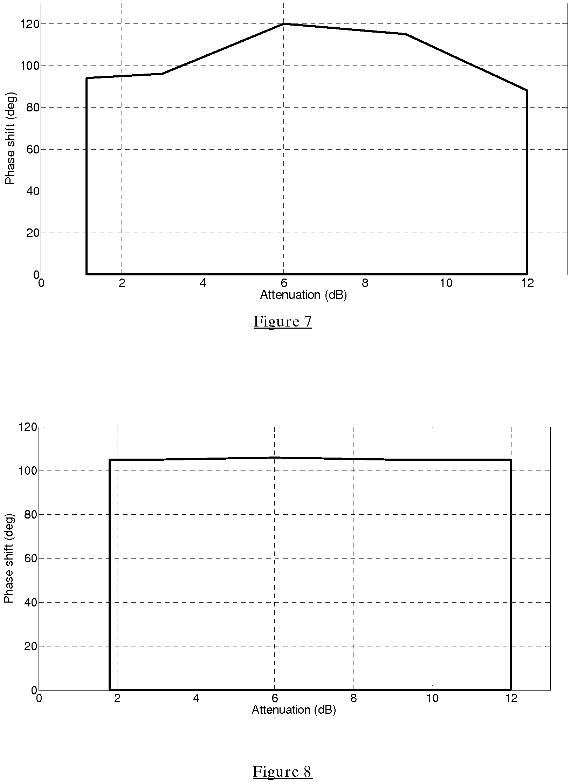

Further, Figs. 7 and 8 depict the polygons delimiting the envelopes of achievable phase-shift and attenuation values at 2.5 GHz for the structures of Figs. 3 and 1C, respectively. Any combination of phase shift and attenuation contained <u>inside</u> the polygons can be realized.

As is evident from these two figures, the amount of achievable phase shift for different attenuation levels of the two structures is comparable. The main differences lie with the facts that (A) the amount of maximum achievable phase shift with the structure of Fig. 3 is weakly dependent on the attenuation level and (B) the minimum achievable insertion loss of the proposed structure of Fig. 3 is lower than that of the structure of Fig. 1C - 1.13 dB as opposed to 1.8 dB.

In summary, the main benefits of the proposed combined attenuator and phase shifter of Fig. 3 are:

1. Lower insertion loss and similar phase shifts compared to the case of the circuit depicted in Fig. 1C - the lower insertion loss is due to the fact that only one 3-dB coupler is needed.

2. Lower cost and smaller volume - again due to the fact that only one 3-dB coupler is required.

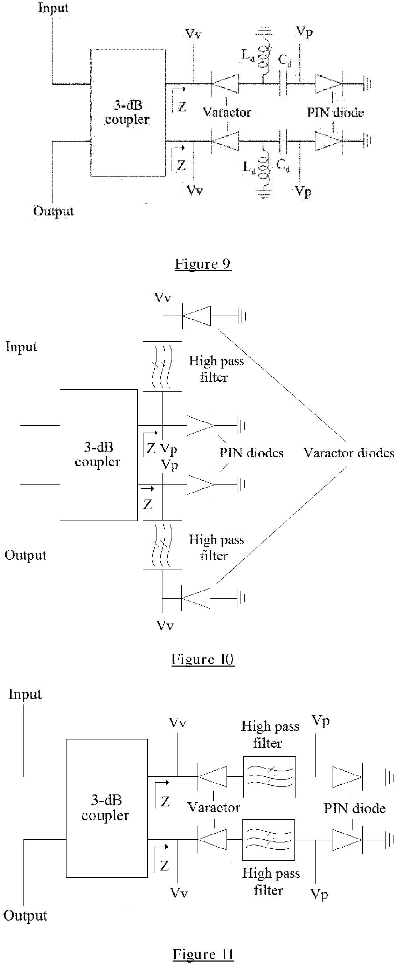

Other pertinent embodiments are presented in Figs. 9, 10, 11 and 12.

Figure 9 shows an embodiment in which the variable capacitor and variable resistors in the form of varactors and PIN diodes respectively are arranged in series and are separated from each other by a decoupling inductor and capacitor. These act to isolate the control signals $V_v$ and $V_p$ from each other allowing independent control of the varactor and PIN diode. It should be noted that in some embodiments where the variable resistor and variable capacitor are formed from transistors for example, then the control signal may be applied to the gate of the transistor and this arrangement may in itself isolate the control signal of the two devices from each other and there would be no need for separate decoupling devices between them.

Figure 10 shows an alternative embodiment where the varactor diode and PIN diodes are arranged in parallel at the two ports and a high pass filter is used to isolate the two control signals from each other. This high pass filter will act as an open circuit to the DC values of these control signals and yet will act as a short circuit to the radio frequency signals that are being phase shifted, attenuated and reflected. Choice of the characteristics of the high pass filter can determine the properties of the device and in particular the speed with which the phase shift and attenuation can be varied as the characteristics of the high pass filter will affect the transient characteristics of the device. In this embodiment, the parallel arrangement of the variable capacitor and resistance mean that any parasitic resistance associated with these devices will be arranged in parallel with each other and as such will be lower than would be the case were they were arranged in series. If arranged in series, such parasitic resistances would be summed.

Figure 11 shows an alternative embodiment in which a high pass filter is arranged between the serial arrangements of the varactor and PIN diodes. This acts to decouple the DC control voltages from each other allowing independent control of the varactor and PIN diodes.

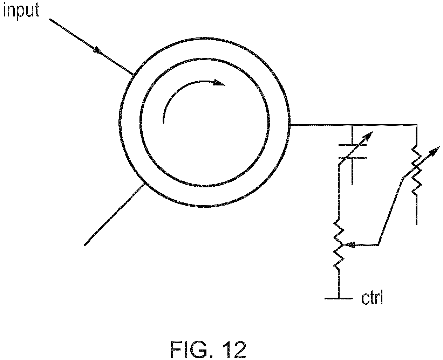

Figure 12 shows a further embodiment in which the directional device is not a 3-dB coupler but is a circulator. In this embodiment, there is an input for a receiving signal, one further port which the input signal is directed to and which comprises a variable capacitor and a variable resistor arranged in parallel and an output port that a reflected signal from the further port is transmitted to. The variable capacitor is controlled to produce the desired amount of phase shift while the variable resistor produces the desired amount of attenuation. In this embodiment, a single control signal is transmitted to control the capacitor and its magnitude is changed by sending it through a potential divider in the form of a resistor to control the variable resistor. In this way, the device can be configured to provide a predetermined phase shift and attenuation.

In summary, the combined variable attenuator and phase shifter based on a single 3-dB coupler leads to a) lower cost, b) a better insertion-loss performance and c) a phase-shift performance comparable to that of a cascade connection of an attenuator and phase shifter that requires two 3-dB couplers.

The specific presented embodiment employing varactor and PIN diodes exhibits a phase-shift range of 0-105° and an attenuation range of 1.13-12 dB. As an example, these attenuation and phase shift ranges are practicable for a number of antenna-array applications, since the ranges allow for antenna beam steering by up to a few beamwidths and a sidelobe reduction by up to about 14 dB.

A number of different attenuation and phase-shift ranges are possible when electronic components other than varactor and PIN diodes are utilized.

Lower insertion loss, lower cost, smaller footprint and volume. Specifically, it was shown that insertion loss was reduced from 1.8 dB to 1.13 dB using only one 3-dB coupler.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1.   A device operable to control a phase shift and attenuation of a signal, said device comprising:

   a directional device comprising an input port for receiving said signal, an output port for outputting an output signal and at least one further port, said directional device being operable to direct said signal received at said input port towards said at least one further port;
   a variable capacitor and variable resistor in data communication with said at least one further port; and
   at least one control signal input operable to receive at least one control signal and to route said at least one control signal to control a capacitance of said variable capacitor and to control a resistance of said variable resistor; wherein
   said at least one further port is operable to reflect said signal, an attenuation and phase shift of said reflected signal depending on said capacitance of said variable capacitor and said resistance of said variable resistor, said directional device being operable to direct said reflected signal towards said output port.

2.   A device according to claim 1, wherein said control signal is routed to at least one of said variable capacitance and said variable resistor via a resistor, a resistance of said resistor determining a magnitude of said control signal input to control said at least one of said variable capacitor and said variable resistor.

3.   A device according to claim 1, wherein said at least one control signal input is operable to receive two control signals, an attenuation control signal and a phase shift control signal, and to route said attenuation control signal to control a resistance of said variable resistor and to route said phase shift control signal to control a capacitance of said variable capacitor.

4.   A device according to any one of claims 1 to 3, wherein said variable capacitor and said variable resistor are arranged in parallel with each other.

5.   A device according to any one of claims 1 to 3, wherein said variable capacitor and said variable resistor are arranged in series with each other.

6.   A device according to any preceding claim, further comprising a high pass filter arranged between said variable capacitor and said variable resistor.

**7.** A device according to claim 6, wherein said high pass filter comprises a decoupling capacitor.

**8.** A device according to any preceding claim, wherein said directional device comprises a circulator.

**9.** A device according to any one of claims 1 to 7, wherein said directional device comprises two further ports, said directional device being operable to direct an input signal from said input to said two further ports, and to direct reflected signals from each of said two further ports to both said input port and said output port; said device further comprising

a further variable capacitor and a further variable impedance, said variable capacitor and said variable resistor being in data communication with one of said two further ports and said further variable capacitor and said further variable resistor being in data communication with another of said two further ports, a phase shift and attenuation of said reflected signals from each of said two further ports depending on a value of a capacitance and resistor of said variable capacitor and said variable resistor in data communication with said respective further port.

**10.** A device according to claim 9, wherein said directional device comprises a 3-dB coupler, and said variable capacitor and said variable resistor are matched to said further variable capacitor and said further variable resistor such that said reflected signals received at said output port from each of said two further ports are substantially the same, and reflected signals received at said input port from each of said two further ports are substantially 180° out of phase with each other.

**11.** A device according to any preceding claim, wherein said variable capacitor comprises at least one of a varactor diode and a transistor.

**12.** A device according to any preceding claim, wherein said variable resistor comprises at least one of a PIN diode and a transistor.

**13.** A method of varying a phase shift and attenuation of a signal, said method comprising:

receiving said signal at an input port of a directional device;
directing said signal towards at least one further port of said directing device;
receiving at least one control signal;
routing said at least one control signal to control a capacitance of a variable capacitor and to control a resistance of a variable resistor;
reflecting said signal at said at least one further port, an attenuation and phase shift of said reflected signal depending on said capacitance of said variable capacitor and said resistance of said variable resistor; and
directing said reflected signal towards an output port of said directional device.

**14.** A method according to claim 13, wherein said step of receiving at least one control signal comprises receiving two control signals, an attenuation control signal and a phase shift control signal; and
said step of routing said control signals comprises routing said attenuation control signal to control a resistance of said variable resistor and routing said phase shift control signal to control a capacitance of said variable capacitor.

**15.** A method according to claim 13 or 14, wherein said directional device is a 3-dB coupler and comprises two further ports, and said directing step comprises directing said signal from said input to said two further ports; and
said step of directing said reflected signals comprises directing said reflected signals from each of said two further ports to both said input port and said output port, a phase shift and attenuation of said reflected signals from each of said two further ports depending on a value of a capacitance of a variable capacitor and a resistance of a variable resistor in data communication with said respective further port, wherein said variable capacitor and said variable resistor at each of said further ports are matched with each other such that said reflected signals received at said output port from each of said two further ports are substantially the same, and reflected signals received at said input port from each of said two further ports are substantially 180 out of phase with each other.

**Amended claims in accordance with Rule 137(2) EPC.**

**1.** A device configured to independently control a phase shift and attenuation of a signal, said device comprising:

a directional device comprising an input port for receiving said signal, an output port for outputting an output signal and at least one further port, said directional device being configured to direct said signal received at said input port towards said at least one further port;

a variable capacitor and variable resistor in electrical connection with said at least one further port; and

at least one control signal input configured to receive at least one control signal and to route said at least one control signal to control a capacitance of said variable capacitor and thereby a phase shift of said signaf and to control a resistance of said variable resistor and thereby an attenuation of said signal; wherein

said at least one further port is configured to reflect said signal, said attenuation and phase shift of said reflected signal depending on said resistance of said variable resistor and said capacitance of said variable capacitor respectively, said directional device being configured to direct said reflected signal towards said output port.

2. A device according to claim 1, wherein said control signal is routed to at least one of said variable capacitance and said variable resistor via a resistor, a resistance of said resistor determining a magnitude of said control signal input to control said at least one of said variable capacitor and said variable resistor.

3. A device according to claim 1, wherein said at least one control signal input is configured to receive two control signals, an attenuation control signal and a phase shift control signal, and to route said attenuation control signal to control a resistance of said variable resistor and to route said phase shift control signal to control a capacitance of said variable capacitor.

4. A device according to any one of claims 1 to 3, wherein said variable capacitor and said variable resistor are arranged in parallel with each other.

5. A device according to any one of claims 1 to 3, wherein said variable capacitor and said variable resistor are arranged in series with each other.

6. A device according to any preceding claim, further comprising a high pass filter arranged between said variable capacitor and said variable resistor.

7. A device according to claim 6, wherein said high pass filter comprises a decoupling capacitor.

8. A device according to any preceding claim, wherein said directional device comprises a circulator.

9. A device according to any one of claims 1 to 7, wherein said directional device comprises two further ports, said directional device being configured to direct an input signal from said input to said two further ports, and to direct reflected signals from each of said two further ports to both said input port and said output port; said device further comprising

a further variable capacitor and a further variable impedance, said variable capacitor and said variable resistor being in electrical connection with one of said two further ports and said further variable capacitor and said further variable resistor being in electrical connection with another of said two further ports, a phase shift and attenuation of said reflected signals from each of said two further ports depending on a value of a capacitance and resistor of said variable capacitor and said variable resistor in electrical connection with said respective further port.

10. A device according to claim 9, wherein said directional device comprises a 3-dB coupler, and said variable capacitor and said variable resistor are matched to said further variable capacitor and said further variable resistor such that said reflected signals received at said output port from each of said two further ports are substantially the same, and reflected signals received at said input port from each of said two further ports are substantially 180 out of phase with each other.

11. A device according to any preceding claim, wherein said variable capacitor comprises at least one of a varactor diode and a transistor.

12. A device according to any preceding claim, wherein said variable resistor comprises at least one of a PIN diode and a transistor.

13. A method of independently varying a phase shift and attenuation of a signal, said method comprising:

receiving said signal at an input port of a directional device;

directing said signal towards at least one further port of said directing device:

receiving at least one control signal,
routing said at least one control signal to control a capacitance of a variable capacitor and thereby a phase shift of said signal and to control a resistance of a variable resistor and thereby an attenuation of said signal, said variable capacitor and said variable resistor being in electrical connection with said at least one further port;
reflecting said signal at said at least one further port, a phase shift and attenuation of said reflected signal depending on said capacitance of said variable capacitor and said resistance of said variable resistor respectively; and
directing said reflected signal towards an output port of said directional device.

14. A method according to claim 13, wherein said step of receiving at least one control signal comprises receiving two control signals, an attenuation control signal and a phase shift control signal; and
said step of routing said control signals comprises routing said attenuation control signal to control a resistance of said variable resistor and routing said phase shift control signal to control a capacitance of said variable capacitor.

15. A method according to claim 13 or 14, wherein said directional device is a 3-dB coupler and comprises two further ports, and said directing step comprises directing said signal from said input to said two further ports; and
said step of directing said reflected signals comprises directing said rejected signals from each of said two further ports to both said input port and said output port, a phase shift and attenuation of said reflected signals from each of said two further ports depending on a value of a capacitance of a variable capacitor and a resistance of a variable resistor in electrical connection with said respective further port, wherein said variable capacitor and said variable resistor at each of said further ports are matched with each other such that said reflected signals received at said output port from each of said two further ports are substantially the same, and reflected signals received at said input port from each of said two further ports are substantially 180° out of phase with each other.

Input

3-dB
coupler

$\overset{\rightarrow}{Z}$

$\overset{\rightarrow}{Z}$

Output

Figure 1A

Input

3-dB
coupler

$\overset{\rightarrow}{Z}$

$\overset{\rightarrow}{Z}$

Output

Figure 1B

Figure 1C

Figure 2

Figure 3

Figure 4

Figure 5A

Figure 5B

Figure 5C

Figure 5D

Figure 5E

Figure 6A

Figure 6B

Figure 6C

Figure 6D

Figure 6E

Figure 7

Figure 8

Figure 9

Figure 10

Figure 11

FIG. 12

Europäisches
Patentamt

European
Patent Office

Office européen
des brevets

# EUROPEAN SEARCH REPORT

Application Number

EP 15 30 5639

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 216 445 A (ABAJIAN ANTHONY [US]) 5 August 1980 (1980-08-05) * column 4, lines 1-41; figure 5 * | 1-15 | INV. H03H7/20 H03H7/25 |
| X | US 2015/108210 A1 (ZHOU LIMING [US]) 23 April 2015 (2015-04-23) * paragraph [0065]; figure 3C * | 1-15 | ADD. H03H7/48 H03H7/52 |
| X | US 2009/280755 A1 (CAMUFFO ANDREA [DE] ET AL) 12 November 2009 (2009-11-12) * paragraphs [0029] - [0032]; figure 5 * | 1-15 | |
| A | US 4 902 983 A (FUJIKI YOSHINORI [JP] ET AL) 20 February 1990 (1990-02-20) * column 3, lines 10-65; figures 1,2 * | 1-15 | |
| A | US 3 423 699 A (HINES MARION E) 21 January 1969 (1969-01-21) * column 2, lines 12-35; figures 1,2 * | 1-15 | |
| A | US 6 335 665 B1 (MENDELSOHN JOSEPH PATRICK [US]) 1 January 2002 (2002-01-01) * figures 1,3,5 * | 1-15 | TECHNICAL FIELDS SEARCHED (IPC) H03H H01P H03G |
| A | EP 2 544 369 A1 (ALCATEL LUCENT [FR]) 9 January 2013 (2013-01-09) * figures 1,2 * | 1-15 | |

-/--

| The present search report has been drawn up for all claims | | |
|---|---|---|
| Place of search | Date of completion of the search | Examiner |
| The Hague | 1 October 2015 | Radomirescu, B-M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 15 30 5639

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SENAD BULJA ET AL: "Variable Reflection-Type Attenuators Based on Varactor Diodes", IEEE TRANSACTIONS ON MICROWAVE THEORY AND TECHNIQUES, IEEE SERVICE CENTER, PISCATAWAY, NJ, US, vol. 60, no. 12, 1 December 2012 (2012-12-01), pages 3719-3727, XP011484688, ISSN: 0018-9480, DOI: 10.1109/TMTT.2012.2216895 * chapter I; figures 1,2 * | 1-15 | |

TECHNICAL FIELDS
SEARCHED (IPC)

The present search report has been drawn up for all claims

| Place of search | Date of completion of the search | Examiner |
|---|---|---|
| The Hague | 1 October 2015 | Radomirescu, B-M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 3 089 365 A1**

## ANNEX TO THE EUROPEAN SEARCH REPORT
## ON EUROPEAN PATENT APPLICATION NO.

EP 15 30 5639

This annex lists the patent family members relating to the patent documents cited in the above-mentioned European search report.
The members are as contained in the European Patent Office EDP file on
The European Patent Office is in no way liable for these particulars which are merely given for the purpose of information.

01-10-2015

| Patent document cited in search report | | Publication date | Patent family member(s) | | Publication date |
|---|---|---|---|---|---|
| US 4216445 | A | 05-08-1980 | CA | 1127725 A1 | 13-07-1982 |
| | | | US | 4216445 A | 05-08-1980 |
| US 2015108210 | A1 | 23-04-2015 | NONE | | |
| US 2009280755 | A1 | 12-11-2009 | DE | 102009019883 A1 | 24-12-2009 |
| | | | US | 2009280755 A1 | 12-11-2009 |
| US 4902983 | A | 20-02-1990 | AU | 605237 B2 | 10-01-1991 |
| | | | AU | 1119288 A | 04-08-1988 |
| | | | CA | 1280180 C | 12-02-1991 |
| | | | DE | 3884635 D1 | 11-11-1993 |
| | | | DE | 3884635 T2 | 27-01-1994 |
| | | | EP | 0277636 A2 | 10-08-1988 |
| | | | US | 4902983 A | 20-02-1990 |
| US 3423699 | A | 21-01-1969 | NONE | | |
| US 6335665 | B1 | 01-01-2002 | NONE | | |
| EP 2544369 | A1 | 09-01-2013 | NONE | | |

EPO FORM P0459

For more details about this annex : see Official Journal of the European Patent Office, No. 12/82